# EUROPEAN PATENT APPLICATION

(11) **EP 4 811 955 A1**
(43) Date of publication of application: **23.09.2026**
(21) Application number: 25213333.5
(22) Date of filing: 04.11.2025
(51) Int. Cl.: H10D 30/01, H10D 30/66, H10D 62/10, H10D 62/13, H10D 62/17, H10D 64/27, H10P 30/22

(54) **TRENCH MOSFET STRUCTURE AND MANUFACTURING METHOD THEREOF**

(30) Priority: 19.03.2025 CN 202510344565
(71) Applicant: Chongqing Alpha and Omega Semiconductor Limited, Chongqing 400700 (CN)
(72) Inventor: TU, GUOHUA, Chongqing, 400700 (CN); WANG, XIAORONG, Chongqing, 400700 (CN)
(74) Representative: Metida

(57) **Abstract**

A trench metal-oxide-semiconductor field-effect transistor (MOSFET) structure and a manufacturing method thereof are provided. The trench MOSFET structure includes an N+ substrate (100), an N- drift region (110), a P-type base region (120), a source metal (400) and a drain source. An N+ source region (140) is disposed on an upper portion of the P-type base region (120). P + regions (130) are respectively disposed on two sides of the N+ source region (140). A trench gate structure is formed in the middle portion of the N+ source region (140). The trench gate structure penetrates the N+ source region (140) downwards and extends into the P-type base region (120). A bottom portion of the trench gate structure is connected to the N- drift region (110) by an N-type region (150). The N-type region (150) is N-type doped. An interlayer dielectric layer (300) is covered on the trench gate structure.

## Description

### TECHNICAL FIELD

The present disclosure relates to a field of power devices, and in particular to a trench metal-oxide-semiconductor field-effect transistor (MOSFET) structure that high-voltage resistant and a manufacturing method thereof.

### BACKGROUND

Trench MOSFETs, or trench metal-oxide-semiconductor field-effect transistors, are important power devices. The trench MOSFETs are widely used in DC-DC converters, voltage regulators, power management modules, electromechanical control, display control, and automotive electronics. Compared to planar MOSFETs, the trench MOSFETs has significant advantages. First, the trench MOSFETs eliminate a junction field effect transistor (JFET) effect, reduce internal impedance and bring a on-resistance closer to an ideal value. Second, the trench MOSFETs allow for a smaller cell size and an increased cell density, thereby increasing a current density and effectively saving a chip area. These significant advantages make the trench MOSFETs superior in power density, efficiency, and heat dissipation.

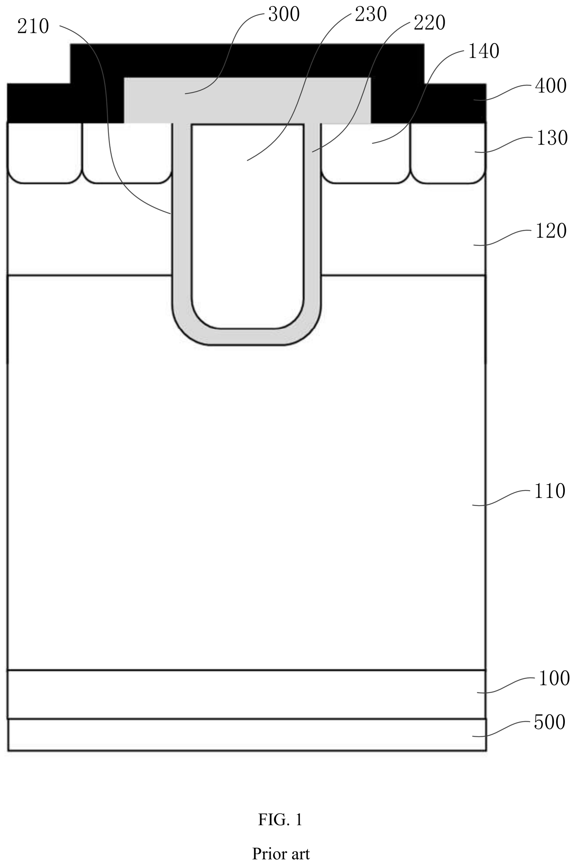

With development of modem circuits, requirements for frequency characteristics of power devices are increasingly stringent. Minimizing a characteristic on-resistance and a gatedrain charge of the trench MOSFETs while ensuring a certain breakdown voltage is a primary design goal. As shown in FIG. 1, in a conventional trench MOSFET structure, a P-type base region 120 thereof is relatively thin, and a trench 210 generally penetrates the P-type base region 120 and extends into a N- drift region 110. In this case, an introduction of the trench 210 leads to electric field concentration at corners of a gate oxide layer 220, which easily causes the gate oxide layer 220 to break down, resulting in serious reliability problems. Furthermore, the conventional trench MOSFET structure has a relatively long conduction channel and a large on-resistance, leaving considerable room for improvement towards an ideal on-resistance.

### SUMMARY

**In** view of shortcomings of the prior art, a technical problem to be solved by the present disclosure is to provide a trench metal-oxide-semiconductor field-effect transistor (MOSFET) structure that is high-voltage resistant and a manufacturing method thereof.

In a first aspect, the present disclosure provides a trench MOSFET structure. The trench MOSFET structure comprises an N+ substrate, an N- drift region, and a P-type base region. The N+ substrate, the N- drift region and the P-type base region are sequentially disposed from bottom to top. The N+ substrate is N-type heavily doped. The N- drift region is N-type lightly doped. The P-type base region is P-type doped.

An N+ source region is disposed on an upper portion of the P-type base region. P + regions are respectively disposed on two sides of the N+ source region. The N+ source region is N-type heavily doped. The P + regions are P-type heavily doped. A trench gate structure is formed in a middle portion of the N+ source region. The trench gate structure penetrates the N+ source region downwards and extends into the P-type base region. A bottom portion of the trench gate structure is connected to the N- drift region by an N-type region. The N-type region is N-type doped.

An interlayer dielectric layer is covered on an upper end of the trench gate structure. A width of the interlayer dielectric layer is greater than a width of the trench gate structure. A source metal is disposed on an upper end of the interlayer dielectric layer, an upper end of the N+ source region and upper ends of the P + regions. A drain metal is disposed on a lower end of the N+ substrate.

Furthermore, the trench gate structure comprises a trench formed in the P-type base region, a gate oxide layer formed on a trench wall of the trench, and a gate filled in the trench.

The gate oxide layer comprises a bottom gate oxide layer formed at a bottom portion of the trench and a sidewall gate oxide layer formed on a sidewall of the trench. A thickness of the bottom gate oxide layer is greater than a thickness of the sidewall gate oxide layer.

Furthermore, the thickness of the sidewall gate oxide layer is 400-600 A. The thickness of the bottom gate oxide layer is 2000 -5000 A than the thickness of the sidewall gate oxide layer.

Furthermore, a depth of the trench is 0.9-1.5 µm.

Furthermore, a width of the N-type region is less than the width of the interlayer dielectric layer. The width of the N-type region is not less than the width of the trench gate structure.

Furthermore, a depth of the N+ source region is greater than a depth of each of the P + regions. A thickness of the interlayer dielectric layer is 0.8-1.3 µm.

Furthermore, the P-type base region is formed by epitaxy on the N- drift region, and a thickness of the P-type base region is 2 -3 µm.

In a second aspect, the present disclosure provides a manufacturing method of an trench MOSFET structure. The manufacturing method comprises steps S100-S600.

The step S100 comprises taking an N+ substrate, and sequentially epitaxially growing an N- drift region and a P-type base region on the N+ substrate. The N+ substrate is N-type heavily doped. The N- drift region is N-type lightly doped. The P-type base region is P-type doped.

The step S200 comprises forming an N+ source region by performing ion implantation on an upper portion of the P-type base region. The N+ source region is N-type heavily doped.

The step S300 comprises manufacturing a trench gate structure and an N-type region. The trench gate structure penetrates the N+ source region from a middle portion of the N+ source region and extends into the P-type base region. A bottom portion of the trench gate structure is connected to the N- drift region through the N-type region. The N-type region is N-type doped.

The step S400 comprises forming P + regions on two sides of the N+ source region by performing ion implantation, and performing high-temperature annealing treatment. The P+ region is P-type heavily doped;

The step S500 comprises manufacturing an interlayer dielectric layer on an upper end of the trench gate structure. Portions of the N+ region on two sides of the trench form platform regions. Two ends of the interlayer dielectric layer respectively extend horizontally and are respectively disposed on the platform regions.

The step S600 comprises manufacturing a source metal at an upper end of the interlayer dielectric layer and an upper end of the P-type base region, and manufacturing a drain metal at a lower end of the N+ substrate.

Furthermore, in the step S200, the N+ source region is formed by inclined implantation, and an inclined angle thereof is 20-40 degrees.

Furthermore, the step S300 comprises steps S310-S350.

The step S310 comprises depositing a first hard mask and forming a trench in a middle portion of the N+ source region by a photolithography and etching process. The trench penetrates the N + source region downwards and extends into the P-type base region.

The step S320 comprises implanting N-type ions at a bottom portion of the trench to form an N-type region connecting the bottom portion of the trench and the N- drift region.

The step S330 comprises depositing a first oxide layer having a thickness of 2000 - 5000 A in the trench, depositing a second hard mask, removing a portion of the oxide layer on a sidewall of the trench by the photolithography and etching process, and retaining a portion of the oxide layer disposed at the bottom portion of the trench.

The step S340 comprises depositing a second oxide layer having a thickness of 400-600A in the trench to form a gate oxide layer.

The step S350 comprises depositing polysilicon in the trench, and etching the polysilicon to form a gate.

In the present disclosure, the P-type base region is formed by epitaxial growth, the thickness of the P-type base region is increased, and the P-type base region completely wraps the trench gate structure. Moreover, the N-type region is formed at the bottom portion of the trench to connect the trench gate structure and the N- drift region. In this way, not only a gate leakage charge is reduced, a switching speed is improved, but also an electric field at the bottom portion of the trench is reduced, so that the gate oxide layer is effectively protected, and reliability of the gate oxide layer is improved. By thickening the gate oxide layer disposed at the bottom portion of the trench, reliability of the gate oxide layer is further improved, so that the reliability of the trench MOSFET is greater. In addition, by increasing the depth of the N+ source region by inclined implantation, a length of a formed conductive channel is shorter, and a resistance of the formed conductive channel is reduced.

### BRIEF DESCRIPTION OF DRAWINGS

FIG. 1 is a conventional trench metal-oxide-semiconductor field-effect transistor (MOSFET structure) of the prior art.
FIG. 2 is a schematic diagram of a trench MOSFET structure according to one embodiment of the present disclosure.
FIG. 3 is a flowchart of a manufacturing method of the trench MOSFET structure according to one embodiment of the present disclosure.
FIG. 4 is a schematic diagram of a structure obtained after growing an N- drift region according to one embodiment of the present disclosure.
FIG. 5 is a schematic diagram of a structure obtained after growing a P-type base region according to one embodiment of the present disclosure.
FIG. 6 is a schematic diagram of a structure obtained after an N+ source region is formed by implantation according to one embodiment of the present disclosure.
FIG. 7 is a schematic diagram of a structure obtained after forming a trench according to one embodiment of the present disclosure.
FIG. 8 is a schematic diagram of a structure obtained after forming an N-type region according to one embodiment of the present disclosure.
FIG. 9 is a schematic diagram of a structure obtained after forming a gate oxide layer according to one embodiment of the present disclosure.
FIG. 10 is a schematic diagram of a structure obtained after forming a gate according to one embodiment of the present disclosure.
FIG. 11 is a schematic diagram of a structure obtained after a P+ region is formed by implantation according to one embodiment of the present disclosure.
FIG. 12 is a schematic diagram of a structure obtained after forming an interlayer dielectric layer according to one embodiment of the present disclosure.

### DETAILED DESCRIPTION

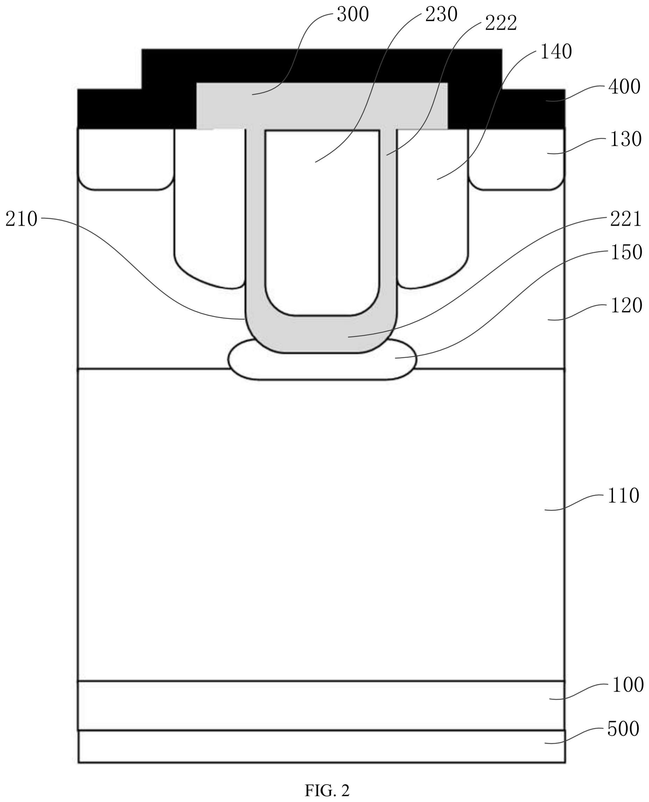

As shown in FIG. 2, the present disclosure provides a trench trench metal-oxide-semiconductor field-effect transistor (MOSFET) structure. The trench MOSFET structure comprises an N+ substrate 100, an N- drift region 110, and a P-type base region 120. The N+ substrate 100, the N- drift region 110 and the P-type base region 120 are sequentially disposed from bottom to top. The N+ substrate 100 is N-type heavily doped. The N- drift region 110 is N-type lightly doped. The P-type base region 120 is P-type doped. In the embodiment, the P-type base region 120 is formed by epitaxially growing on the N- drift region 110, thereby greatly increasing a thickness of the P-type base region 120. The thickness of the P-type base region 120 is 2-3µm.

An N+ source region 140 is disposed on an upper portion of the P-type base region 120. P + regions 130 are respectively disposed on two sides of the N+ source region 140. The N+ source region 140 is N-type heavily doped. The P + regions 130 are P-type heavily doped. In the embodiment, a depth of the N+ source region 140 is greater than a depth of each of the P+ regions 130, which makes a length of a conductive channel formed when conduction shorter, thereby reducing a resistance of the conductive channel.

A trench gate structure is formed in a middle portion of the N+ source region 140. The trench gate structure penetrates the N+ source region 140 downwards and extends into the P-type base region 120. The trench gate structure comprises a trench 210 formed in the P-type base region 120, a gate oxide layer 220 formed on a trench wall of the trench 210, and a gate 230 filled in the trench 210. A depth of the trench 210 is 0.9-1.5 µm. In the embodiment, the gate oxide layer 220 comprises a bottom gate oxide layer 221 formed at a bottom portion of the trench 210 and a sidewall gate oxide layer 222 formed on a sidewall of the trench. A thickness of the bottom gate oxide layer 221 is greater than a thickness of the sidewall gate oxide layer 222. The thickness of the sidewall gate oxide layer 222 is 400-600 A. The thickness of the bottom gate oxide layer 221 is 2000 -5000 A than the thickness of the sidewall gate oxide layer 222.

In the present disclosure, the P-type base region 120 formed by epitaxial growth is thick enough to completely wrap the trench gate structure. In this way, not only a gate leakage charge is reduced, a switching speed is improved, but also an electric field at the bottom portion of the trench is reduced, so that the gate oxide layer 220 is effectively protected, and reliability of the gate oxide layer 220 is improved. By thickening the bottom gate oxide layer 221, the reliability of the gate oxide layer 220 is further improved.

A bottom portion of the trench gate structure is connected to the N- drift region 110 by an N-type region 150. The N-type region 150 is N-type doped. An interlayer dielectric layer 300 is covered on an upper end of the trench gate structure. A thickness of the interlayer dielectric layer 300 is 0.8-1.3µm. A width of the interlayer dielectric layer 300 is greater than a width of the trench gate structure. A width of the N-type region 150 is less than the width of the interlayer dielectric layer 300. The width of the N-type region 150 is not less than the width of the trench gate structure. In this way, withstand voltage performance of the trench MOSFET structure is ensured. A source metal 400 is disposed on an upper end of the interlayer dielectric layer 300, an upper end of the N+ source region 140 and upper ends of the P + regions 130. Of course, a passivation layer is generally disposed on the source metal 400. A drain metal 500 is disposed on a lower end of the N+ substrate 100.

In the present disclosure, by increasing the thickness of the P-type base region 120, the P-type base region 120 completely wraps the trench gate structure. Moreover, the N-type region 150 is formed at the bottom portion of the trench 210 to connect the trench gate structure and the N- drift region 110. In this way, not only a gate leakage charge is reduced, a switching speed is improved, but also an electric field at the bottom portion of the trench 210 is reduced, so that the gate oxide layer 220 is effectively protected, and reliability of the gate oxide layer 220 is improved. By thickening the gate oxide layer 220 disposed at the bottom portion of the trench 210, reliability of the gate oxide layer is further improved, so that the reliability of the trench MOSFET is greater. In addition, by increasing the depth of the N+ source region 140 by inclined implantation, a length of a formed conductive channel is shorter, and a resistance of the formed conductive channel is reduced.

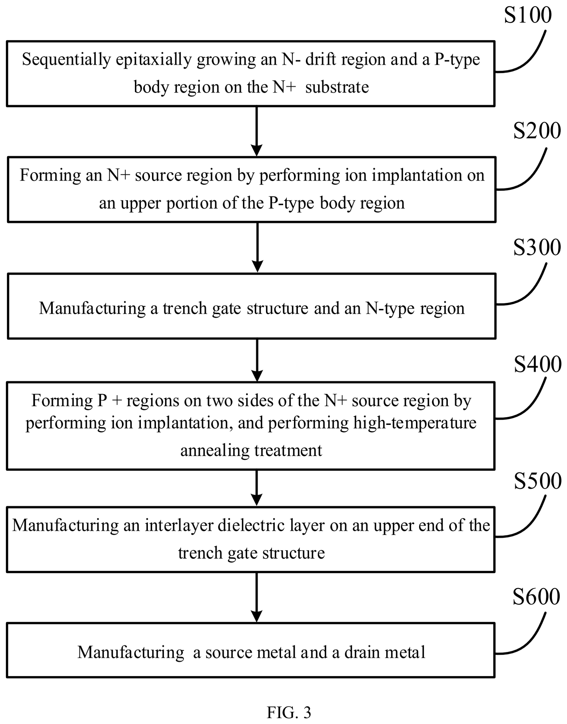

As shown in FIG. 3, FIG. 3 is a flowchart of a manufacturing method of the trench MOSFET structure according to one embodiment of the present disclosure. The manufacturing method comprises steps S100-S600.

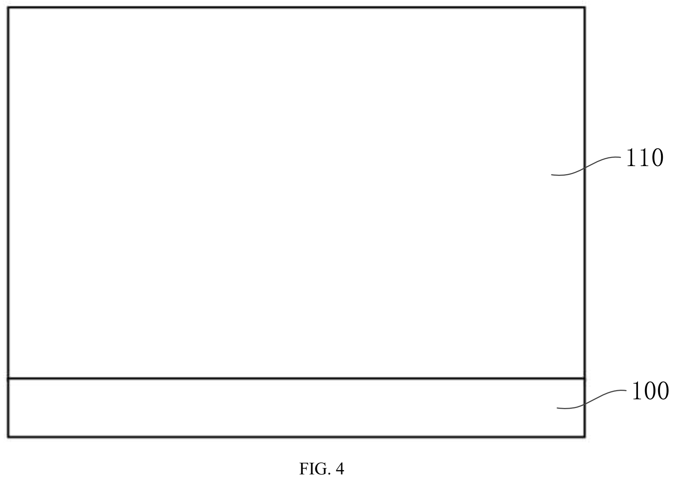

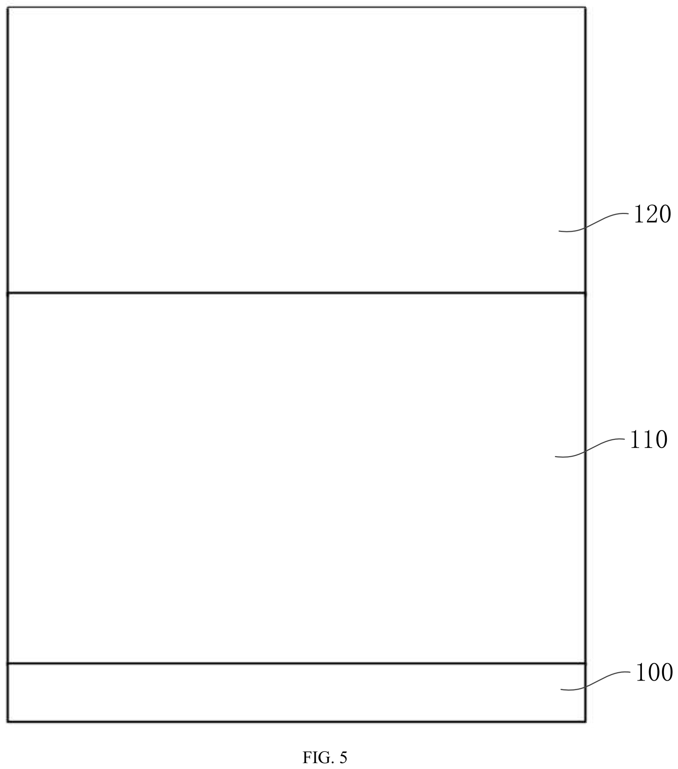

As shown in FIGS. 4-5, the step S100 comprises taking an N+ substrate 100, epitaxially growing an N- drift region 110 on the N+ substrate 100, and epitaxially growing a P-type base region 120 on the N- drift region 110. The N+ substrate 100 is N-type heavily doped. The N- drift region 110 is N-type lightly doped. The P-type base region 120 is P-type doped. In the embodiment, an additional epitaxial process is performed to separately form the P-type base region 120, thereby significantly increasing the thickness of the P-type base region 120. The thickness of the P-type base region 120 is 2-3µm, so as to completely wrap the trench gate structure in a subsequent process.

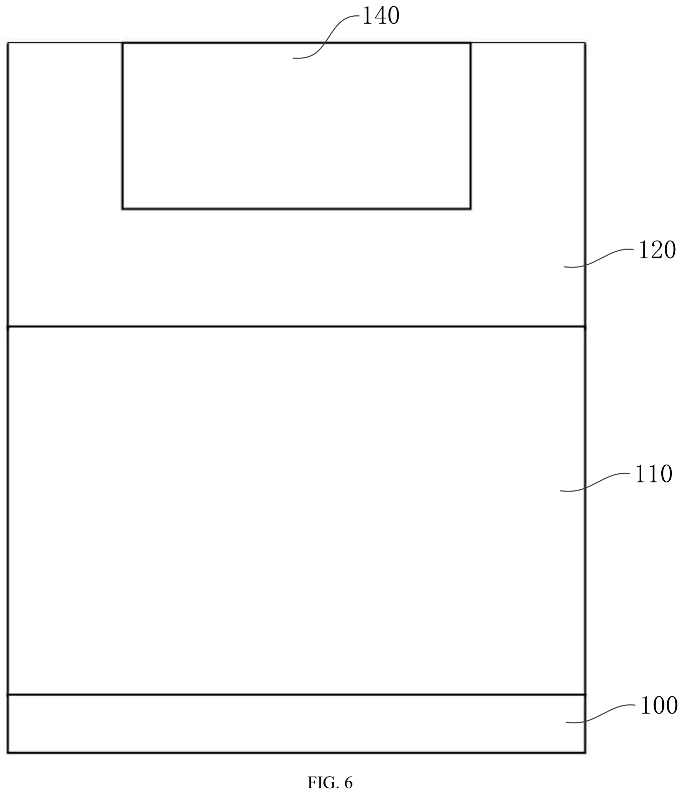

As shown in FIG. 6, the step S200 comprises after depositing a third hard mask on an upper portion of the P-type base region 120, forming an N+ source region 140 by implanting N-type ions of a predetermined concentration. The N+ source region 140 is N-type heavily doped. In the embodiment, the N+ source region 140 is formed by inclined implantation, and an inclined angle thereof is 20-40 degrees, thereby increasing a depth of the N+ source region 140.

The step S300 comprises manufacturing a trench gate structure and an N-type region 150. The trench gate structure penetrates the N+ source region 140 from a middle portion of the N+ source region 140 and extends into the P-type base region 120. A bottom portion of the trench gate structure is connected to the N- drift region 110 through the N-type region 150. The N-type region 150 is N-type doped.

Furthermore, the step S300 comprises steps S310-S350.

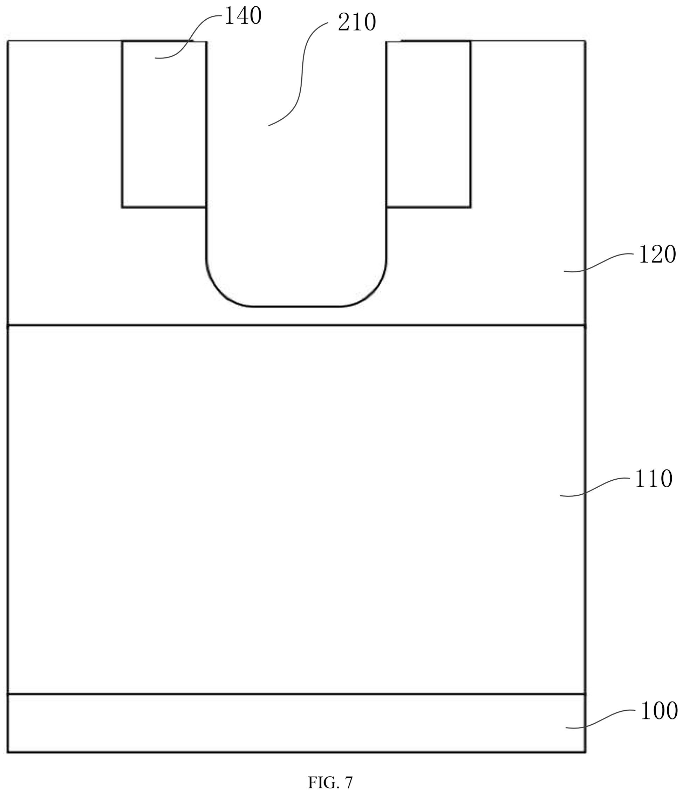

As shown in FIG. 7, the step S310 comprises depositing a first hard mask and forming a trench in a middle portion of the N+ source region 140 by a photolithography and etching process. The trench 210 penetrates the N+ source region 140 downwards and extends into the P-type base region 120. A depth of the trench 210 is 0.9-1.5 µm. Since the thickness of the P-type base region 120 is increased by epitaxially growing the P-type base region 120 separately, the P-type base region 120 is enabled to completely wrap the trench 210 and the trench 210 is unable to extend into the N- drift region 110.

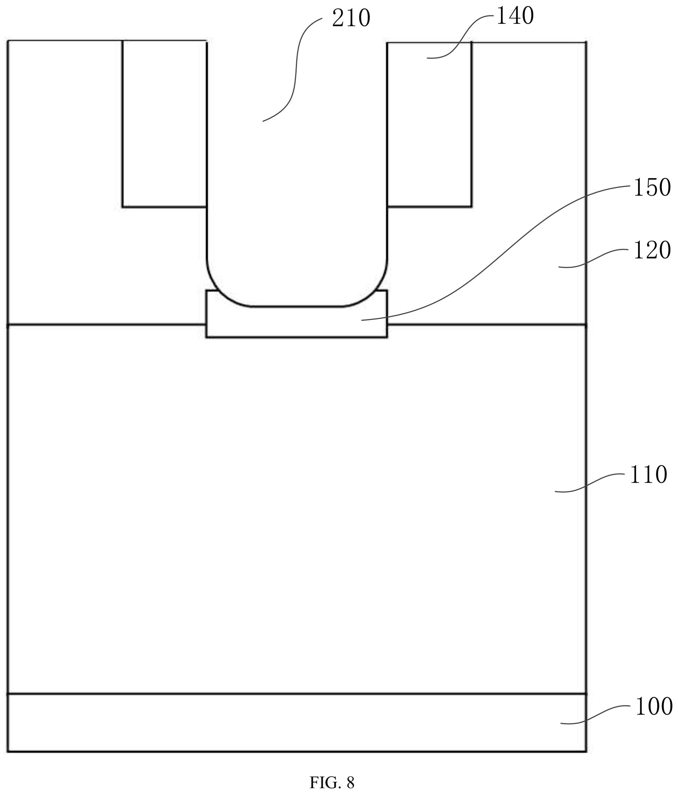

As shown in FIG. 8, the step S320 comprises implanting N-type ions at a bottom portion of the trench 210 to form an N-type region 150 connecting the bottom portion of the trench 210 and the N- drift region 110. The N-type region 150 is N-type doped, and a width of the N-type region 150 is generally not less than a width of the trench 210. To ensure breakdown voltage performance of the trench MOSFET, the width of the N-type region 150 is generally less than a width of the subsequently formed interlayer dielectric layer 300.

The step S330 comprises depositing a first oxide layer having a thickness of 2000 - 5000 A in the trench 210, depositing a second hard mask, removing a portion of the oxide layer on a sidewall of the trench by the photolithography and etching process, and retaining a portion of the oxide layer disposed at the bottom portion of the trench. In this way, a thickness of a gate oxide layer at the bottom portion of the trench 210 is increased.

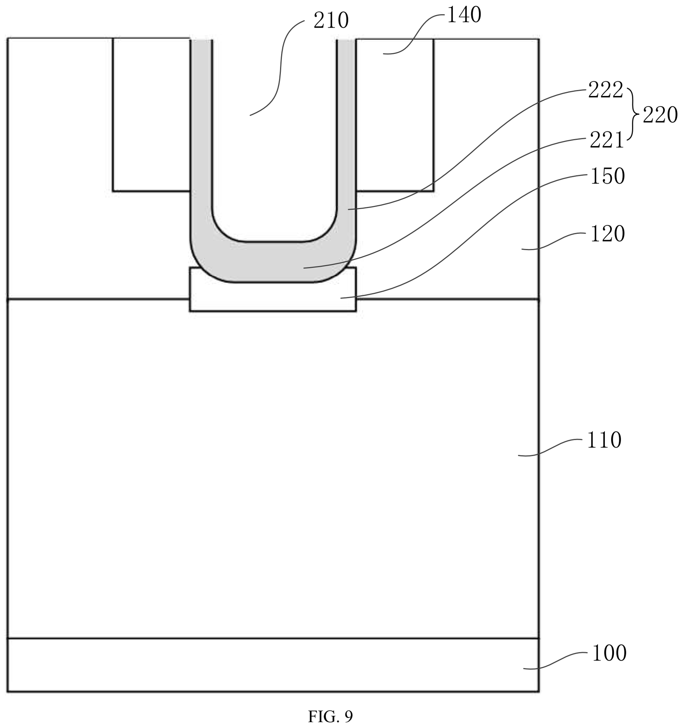

As shown in FIG. 9, the step S340 comprises depositing a second oxide layer having a thickness of 400-600A in the trench to form the gate oxide layer 220. That is, the gate oxide layer 220 comprises a bottom gate oxide layer 221 formed at the bottom portion of the trench 210 and a sidewall gate oxide layer 222 formed on a sidewall of the trench 210. A thickness of the sidewall gate oxide layer 222 is 400-600 A. The thickness of the bottom gate oxide layer 221 is 2000 -5000 A than the thickness of the sidewall gate oxide layer 222.

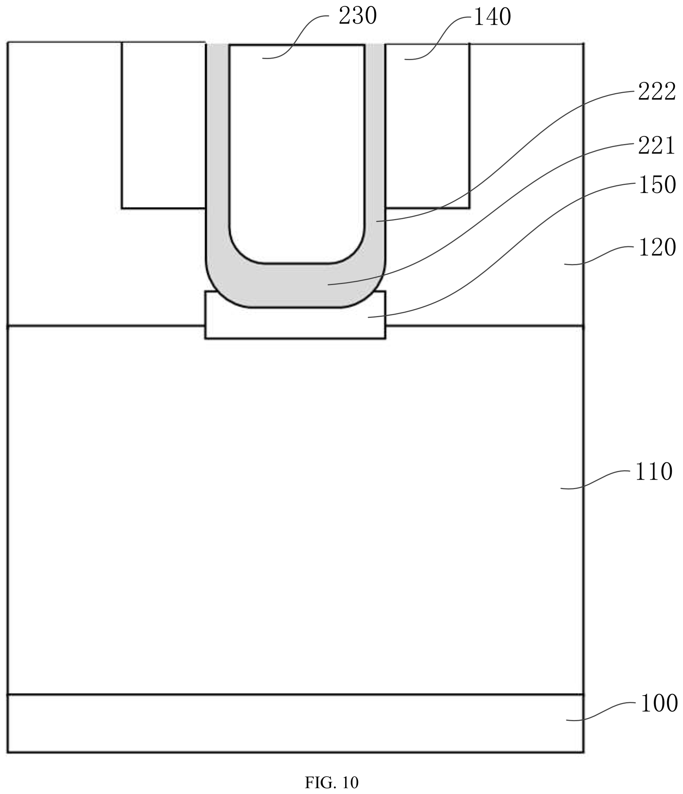

As shown in FIG. 10, the step S350 comprises depositing polysilicon in the trench 210, and etching the polysilicon to form a gate 230. In this way, the manufacture of the trench gate structure and the N-type region 150 is completed.

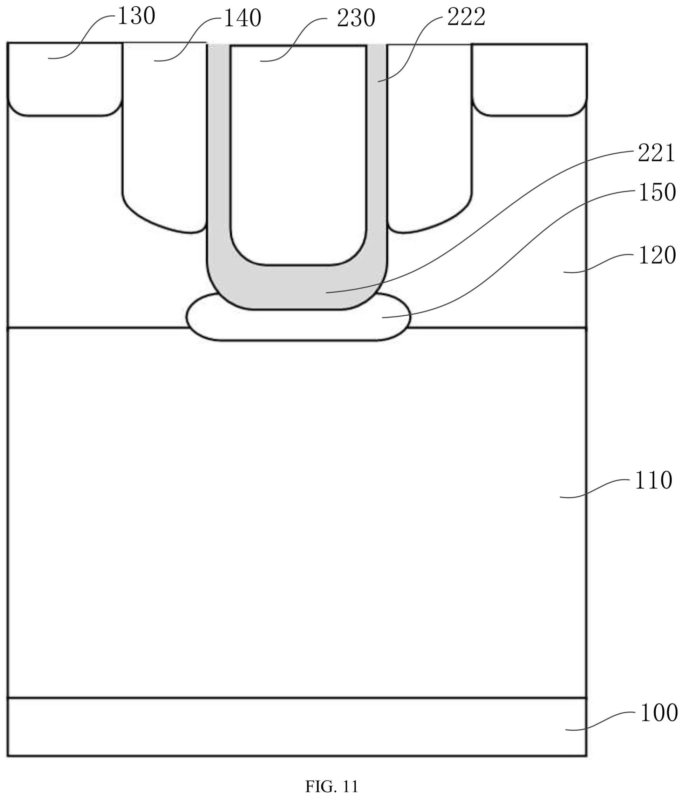

As shown in FIG. 11, the step S400 comprises Step 11 depositing a fourth hard mask, and then forming P + regions 130 on two sides of the N+ source region 140 by a photolithography and etching process after forming patterns of the P + regions 130 on two sides of the N + source region 140. The P + region 130 is P-type heavily doped, which is formed by implanting Al ions. Afterwards, it undergoes high-temperature annealing for a period of time under a predetermined temperature environment.

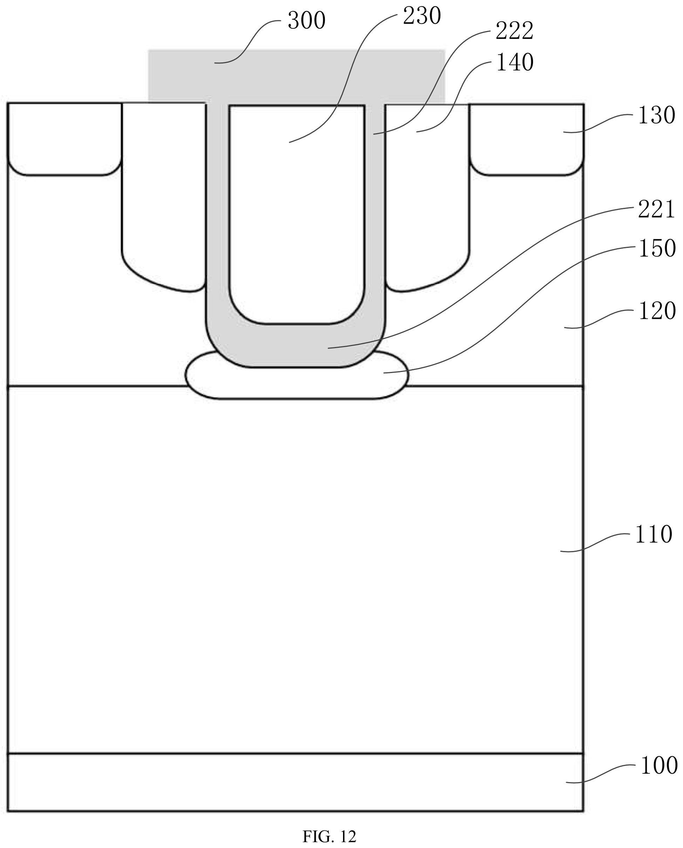

As shown in FIG. 12, the step S500 comprises manufacturing an interlayer dielectric layer 300 on an upper end of the trench gate structure. Portions of the N+ region on two sides of the trench form platform regions. Two ends of the interlayer dielectric layer 300 respectively extend horizontally and are respectively disposed on the platform regions.

Of course, a Ni layer is commonly deposited on a front side of the interlayer dielectric layer 300, and is etched by photolithography. After annealing, contact regions are formed on the upper ends of the P+ regions. Since the structures are conventional structures in the prior art and are not related to the improvement of the embodiment, the contact regions are not shown in the figures.

As shown in FIG. 2, the step S600 comprises manufacturing a source metal 400 at an upper end of the interlayer dielectric layer 300 and an upper end of the P-type base region 120, and manufacturing a drain metal 500 at a lower end of the N+ substrate 100. The step 600 comprises steps S610-S620.

The step S610 comprises depositing a metal layer on a front side, and forming the source metal 400 by photolithography etching. Generally, a passivation material is further deposited and a passivation layer is formed by photolithography etching. However, the passivation layer is a conventional structure in the prior art, and is not related to the improvements of the present disclosure, so it is not shown in the figures.

The step S620 comprises after completing the foregoing processes, a back side of the N+ substrate is ground to a predetermined thickness and is polished, cleaned, evaporated, and alloyed sequentially to form a back side metal as the drain metal 500.

In the present disclosure, the P-type base region 120 is formed by epitaxial growth, the thickness of the P-type base region 120 is increased, and the P-type base region 120 completely wraps the trench gate structure. Moreover, the N-type region 150 is formed at the bottom portion of the trench to connect the trench gate structure and the N- drift region 110. In this way, not only a gate leakage charge is reduced, a switching speed is improved, but also an electric field at the bottom portion of the trench is reduced, so that the gate oxide layer is effectively protected, and reliability of the gate oxide layer is improved. By thickening the gate oxide layer disposed at the bottom portion of the trench, reliability of the gate oxide layer is further improved, so that the reliability of the trench MOSFET is greater. In addition, by increasing the depth of the N+ source region 140 by inclined implantation, a length of a formed conductive channel is shorter, and a resistance of the formed conductive channel is reduced.

## Claims

1. A metal-oxide-semiconductor field-effect transistor (MOSFET) structure, comprising:
an N+ substrate (100);
an N- drift region (110); and
a P-type base region (120);
wherein the N+ substrate (100), the N- drift region (110), and the P-type base region (120) are sequentially disposed from bottom to top, the N+ substrate (100) is N-type heavily doped, the N- drift region (110) is N-type lightly doped, and the P-type base region (120) is P-type doped;
wherein an N+ source region (140) is disposed on an upper portion of the P-type base region (120), P + regions (130) are respectively disposed on two sides of the N+ source region (140), the N+ source region (140) is N-type heavily doped, and the P + regions (130) are P-type heavily doped;
wherein a trench gate structure is formed in a middle portion of the N+ source region (140), and the trench gate structure penetrates the N+ source region (140) downwards and extends into the P-type base region (120);
wherein a bottom portion of the trench gate structure is connected to the N- drift region (110) by an N-type region (150), and the N-type region (150) is N-type doped; wherein an interlayer dielectric layer (300) is covered on an upper end of the trench gate structure, and a width of the interlayer dielectric layer (300) is greater than a width of the trench gate structure;
wherein a source metal (400) is disposed on an upper end of the interlayer dielectric layer (300), an upper end of the N+ source region (140) and upper ends of the P + regions (130), and a drain metal (500) is disposed on a lower end of the N+ substrate (100).

2. The trench MOSFET structure of claim 1, wherein the trench gate structure comprises a trench (210) formed in the P-type base region (120), a gate oxide layer (220) formed on a trench wall of the trench (210), and a gate (230) filled in the trench (210);
wherein the gate oxide layer (220) comprises a bottom gate oxide layer (221) formed at a bottom portion of the trench (210) and a sidewall gate oxide layer (222) formed on a sidewall of the trench (210), and a thickness of the bottom gate oxide layer (221) is greater than a thickness of the sidewall gate oxide layer (222).

3. The trench MOSFET structure of claim 1, wherein the thickness of the sidewall gate oxide layer (222) is 400-600 A, and the thickness of the bottom gate oxide layer (221) is 2000 -5000 A than the thickness of the sidewall gate oxide layer (222).

4. The trench MOSFET structure of claim 2, wherein a depth of the trench is 0.9-1.5 µm.

5. The trench MOSFET structure of claim 2, wherein a width of the N-type region (150) is less than the width of the interlayer dielectric layer (300), and the width of the N-type region (150) is not less than the width of the trench gate structure.

6. The trench MOSFET structure of any one of claims 1-5, wherein a depth of the N+ source region (140) is greater than a depth of each of the P + regions (130); and/or
a thickness of the interlayer dielectric layer (300) is 0.8-1.3 µm.

7. The trench MOSFET structure of any one of claims 1-5, wherein the P-type base region (120) is formed by epitaxy on the N- drift region (110), and a thickness of the P-type base region (120) is 2 -3 µm.

8. A manufacturing method of a trench MOSFET structure, comprising steps:
S100: taking an N+ substrate (100), and sequentially epitaxially growing an N- drift region (110) and a P-type base region (120) on the N+ substrate (100); wherein the N+ substrate (100) is N-type heavily doped, the N- drift region (110) is N-type lightly doped, and the P-type base region (120) is P-type doped;
S200: forming an N+ source region (140) by performing ion implantation on an upper portion of the P-type base region (120); wherein the N+ source region (140) is N-type heavily doped;
S300: manufacturing a trench gate structure and an N-type region (150); wherein the trench gate structure penetrates the N+ source region (140) from a middle portion of the N+ source region (140) and extends into the P-type base region (120), a bottom portion of the trench gate structure is connected to the N- drift region (110) through the N-type region (150), and the N-type region (150) is N-type doped;
S400: forming P + regions (130) on two sides of the N+ source region (140) by performing ion implantation, and performing high-temperature annealing treatment; wherein the P+ region is P-type heavily doped;
S500: manufacturing an interlayer dielectric layer (300) on an upper end of the trench gate structure; wherein portions of the N+ region on two sides of the trench form platform regions, and two ends of the interlayer dielectric layer (300) respectively extend horizontally and are respectively disposed on the platform regions; and
S600: manufacturing a source metal (400) at an upper end of the interlayer dielectric layer (300) and an upper end of the P-type base region (120), and manufacturing a drain metal (500) at a lower end of the N+ substrate (100).

9. The manufacturing method of claim 8, wherein in the step S200, the N+ source region (140) is formed by inclined implantation, and an inclined angle thereof is 20-40 degrees.

10. The manufacturing method of claim 8, wherein the step S300 comprises following steps:
S310: depositing a first hard mask and forming a trench (210) in a middle portion of the N+ source region (140) by a photolithography and etching process, wherein the trench (210) penetrates the N+ source region (140) downwards and extends into the P-type base region (120);
S320: implanting N-type ions at a bottom portion of the trench (210) to form an N-type region (150) connecting the bottom portion of the trench (210) and the N- drift region (110);
S330: depositing a first oxide layer having a thickness of 2000-5000 A in the trench (210), depositing a second hard mask, removing a portions of the oxide layer on a sidewall of the trench (210) by the photolithography and etching process, and retaining a portion of the oxide layer disposed at the bottom portion of the trench (210);
S340: depositing a second oxide layer having a thickness of 400-600A in the trench (210) to form a gate oxide layer (220); and
S350: depositing polysilicon in the trench (210), and etching the polysilicon to form a gate (230).
